# EUROPÄISCHE PATENTSCHRIFT

(11) **EP 1 597 838 B1**
(45) Veröffentlichungstag und Bekanntmachung des Hinweises auf die Patenterteilung: **06.01.2010**
(21) Anmeldenummer: 04715246.7
(22) Anmeldetag: 27.02.2004
(51) Int. Cl.: H04B 7/005, H03G 3/30

(54) **SCHALTUNGSANORDNUNG UND VERFAHREN ZUR KOMPENSATION VON SIGNALPEGELSPRÜNGEN IN VERSTÄRKUNGSEINRICHTUNGEN**
CIRCUIT AND METHOD FOR COMPENSATING SIGNAL LEVEL JUMPS IN AMPLIFICATION DEVICES
CIRCUIT ET PROCEDE POUR COMPENSER DES SAUTS DE NIVEAU DE SIGNAL DANS DES DISPOSITIFS D'AMPLIFICATION

(30) Priorität: 28.02.2003 DE 10308923
(43) Veröffentlichungstag der Anmeldung: 23.11.2005
(73) Patentinhaber: Infineon Technologies AG, 85579 Neubiberg (DE)
(72) Erfinder: FISCHER, Frank, 81827 München (DE); KLEIN, Horst, 85570 Markt Schwaben (DE); KRUG, Erwin, 81927 München (DE); PFLAUM, Bernd, 82008 Unterhaching (DE)
(74) Vertreter: Viering, Jentschura & Partner
(86) Internationale Anmeldenummer: PCT/DE2004/000370
(87) Internationale Veröffentlichungsnummer: WO 2004/077492

(56) Entgegenhaltungen:
- EP-A- 1 026 833
- WO-A-02/37673
- US-A- 5 193 223
- US-A- 6 118 988
- US-A1- 2001 028 244
- US-B1- 6 370 203

## Beschreibung

Die vorliegende Erfindung betrifft eine Schaltungsanordnung aus zwei einstellbaren Verstärkungseinrichtungen, bei der der Signalausgang der ersten Verstärkungseinrichtung mit dem Signaleingang der zweiten Verstärkungseinrichtung verbunden ist.

Um leistungsschwache, empfangene Funksignale, beispielsweise Rundfunk- oder Fernsehsignale verarbeiten zu können, werden die Signale von einem rauscharmen Eingangsverstärker verstärkt, um ein gutes Signal/Rauschverhältnis zu erhalten. Der rauscharme Eingangsverstärker (Low Noise Amplifier) ist zudem sehr breitbandig ausgebildet, um alle im Nutzbereich befindlichen Signale erfassen zu können. Danach wird das verstärkte, sich auf einer HF-Frequenz befindliche Signal auf eine Zwischenfrequenz umgesetzt, um auf dieser weiter verarbeitet zu werden. Das eigentliche schmalbandigere Nutzsignal wird nach der Frequenzumsetzung durch Filter selektiert und dabei nochmals gedämpft. Die durch Frequenzumsetzung sowie durch die Filterung hervorgerufene Dämpfung wird durch einen zweiten und gegebenenfalls dritten Verstärker kompensiert.

Ein Beispiel für eine Frequenzumsetzung mit zwei geregelten Verstärkern, welche eine komplementäre Regelcharakteristik besitzen ist in EP 1026833 gegeben.

Verstärkungseinrichtungen dieser Art, die vor allem bei Fernsehsystemen vorkommen, benötigen daher sowohl eine geringe Rauschzahl als auch eine hohe Großsignalfestigkeit, um ungewünschte Intermodulationsprodukte zu reduzieren. Um beide an sich widersprüchliche Eigenschaften zu erreichen, müssen externe Verstärkerschaltungen verwendet werden, die einen hohen Platz- und Kostenaufwand haben.

Zur Reduzierung des Platz- und Kostenbedarfs wurde vorgeschlagen, digitale arbeitende Regelverstärker (Programmable Gain Amplifier PGA) als Eingangsverstärker zu verwenden, der seine Verstärkung in einstellbaren Stufen regelt und zudem vorteilhaft eine sehr geringe Rauschzahl aufweist. Dadurch ist trotz sehr geringer Eingangspegel ein gutes Signal/Rauschverhältnis gewährleistet. Verstärker dieser Art besitzen jedoch den Nachteil, daß bei einer Änderung der Verstärkungseinstellung, hervorgerufen durch statische Pegelschwankungen ein Pegelsprung am Ausgangssignal auftritt. Dieser Pegelsprung wird aufgrund der Zeitkonstante durch die zweite Verstärkerstufe nur langsam ausgeregelt. Bei digital modulierten Signalen können dadurch zusätzliche Bitfehler aufgrund falscher Amplitudenwerte auftreten. Um daher ein Nachregeln des zweiten Verstärkers zu verhindern, wird das Ausgangssignal des digitalen ersten Regelverstärkers während seines Schaltvorgangs ausgeblendet. Dadurch ist jedoch eine kontinuierliche Übertragung nicht möglich oder es treten im Datenstrom Lücken auf. Aus diesen Gründen wurden Verstärkersysteme aus digitalen und analogen Regelverstärkern bislang nicht verwendet.

Es ist daher Aufgabe der Erfindung, eine Schaltungsanordnung und ein Verfahren vorzusehen, die eine kontinuierliche Verstärkung ermöglicht.

Diese Aufgabe wird mit den Merkmalen der nebengeordneten Patentansprüche dadurch gelöst, daß eine Schaltungsanordnung vorgesehen ist, die eine erste Verstärkungseinrichtung mit digitalem Eingang zur Regelung der Verstärkung und eine dazu in Serie geschaltete zweite Verstärkungseinrichtung ebenfalls mit einem Eingang zur Regelung der Verstärkung aufweist. Die beiden Regeleingänge der ersten und der zweiten Verstärkungseinrichtung sind dabei miteinander derart verbunden, daß bei einer Änderung des Stellsignals der ersten Verstärkungseinrichtung in eine Richtung eine Regelung der Verstärkung der zweiten Verstärkungseinrichtung in die entgegengesetzte Richtung erfolgt.

Durch Anlegen eines Stellsignals an den Regeleingang der beiden Verstärkungseinrichtungen wird in der Schaltungsanordnung ein Nutzsignal mit einem definierten Faktor verstärkt. Mittels einer Verstärkungsänderung in der ersten Verstärkungseinrichtung über den Regeleingang wird die Verstärkung der zweiten Verstärkungseinrichtung in die entgegengesetzte Richtung derart geändert, daß die Gesamtverstärkung der Schaltungsanordnung im wesentlichen gleich bleibt. Dadurch ist eine kontinuierliche Verstärkung auch während einer stufenförmigen Änderung der Verstärkung der ersten Einrichtung gewährleistet.

Vorteilhaft weitere Ausgestaltungen der Erfindung sind Gegenstand der Unteransprüche.

Eine Weiterbildung der Erfindung ist es, den Regeleingang der zweiten Verstärkungseinrichtung als analogen Eingang auszubilden. Das digitale Pegelsignal der ersten Verstärkungseinrichtung wird über einen Digital/Analog-Konverter in ein analoges Signal umgewandelt und dem Regeleingang der zweiten Verstärkungseinrichtung zugeführt.

Weiterbildend kann am Ausgang der ersten Verstärkungseinrichtung ein Pegeldetektor vorgesehen sein, der nach einem Pegelvergleich mit einem oberen und einem unteren Grenzwert ein entsprechendes Signal abgibt.

In diesem Zusammenhang ist es besonders vorteilhaft, wenn die Schaltungsanordnung durch eine Einstellvorrichtung gekennzeichnet ist, die mit dem Regeleingang der Verstärkungseinrichtung und das von dem Pegeldetektor abgegebene Signal zu einer Erzeugung eines Einstellsignals aus n Bit zur Regelung der Verstärkungseinrichtung verwendet.

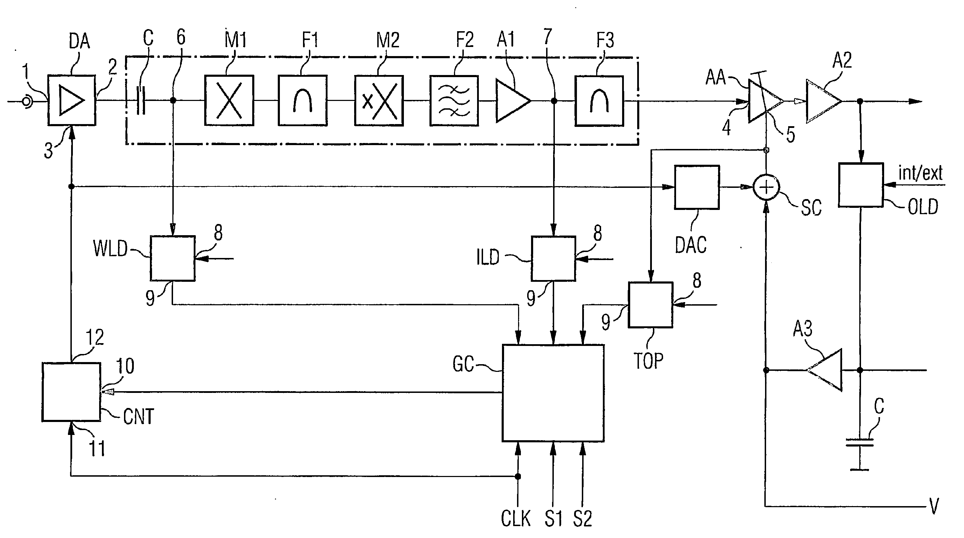

Im folgenden wird die Erfindung anhand eines Ausführungsbeispiels unter Bezugnahme auf die Figur 1 im Detail erläutert.

Die erfindungsgemäße Schaltungsanordnung zeigt einen ersten digitalen Regelverstärker DA mit einem Eingang 1, einem Ausgang 2, und einem digitalen Regeleingang 3. Der Ausgang 2 des Verstärkers DA ist mit einer Einrichtung zur Frequenzumsetzung UDC verbunden. Diese weist einen Kondensator C zur Trennung des Nutzsignalpfades vom Gleichstrompfad, einen Frequenzumsetzer M1, einen Filter F1, einen Frequenzumsetzer M2, einen Bandpaßfilter F2 sowie eine Verstärkungseinrichtung mit fester Verstärkung A1 und einen weiteren Filter F3 auf. Die Filter F1 und F3 sind als SAW-Filter mit fester Frequenz ausgebildet.

Der Ausgang der Einrichtung zur Frequenzumsetzung ist mit einer zweiten Verstärkungseinrichtung AA verbunden, die ebenfalls als Regelverstärker ausgebildet ist. Der Verstärker AA weist einen analogen Regeleingang 5 auf, der mit einer Spannungsquelle V verbunden ist. Am Ausgang der Verstärkungseinrichtung AA wird das empfangene und frequenzumgesetzte Signal nochmals verstärkt und dann abgegriffen.

Der digitale Regeleingang 3 der Verstärkungseinrichtung DA führt zu einer Einstellvorrichtung CNT sowie zu einer Einrichtung DAC, die zumindest einen Digital-Analog-Konverter umfasst. Der Ausgang des Konverters DAC ist mit einer Summenschaltung SC verbunden, die das Ausgangssignal des Konverters DAC mit dem Spannungssignal der als Spannungsquelle arbeitenden Verstärkungseinrichtung A3 summiert und dem Regeleingang 5 der Verstärkungseinrichtung AA zuführt. Der Regeleingang 5 der Verstärkungseinrichtung AA ist ferner mit einer Vergleichsanordnung TOP verbunden, die einen Vergleichseingang 8 mit einem aus 8 Bit bestehenden Signal sowie Ausgang 9 aufweist, dessen Signal aus 2 Bit besteht.

Am Ausgang der Verstärkungseinrichtung AA, die mit einem weiteren Verstärker A2 verbunden ist, ist das frequenzumgesetzte Signal abgreifbar und wird durch die Pegeldetektionseinrichtung OLD gemessen. Der Ausgang der Detektionseinrichtung OLD regelt den Eingang eines Verstärkers A3. Dazu verwendet die Einrichtung OLD einen externen vorgegeben oder einen internen Wert. Somit ist es möglich, daß bei Bedarf beispielsweise die Demodulationseinrichtung einen Spannungswert kann, auf den geregelt werden soll. Der Verstärker A3 ist mit der Summenschaltung SC verbunden und regelt damit einen Teil der Regelspannung am Eingang der Verstärkungseinrichtung AA so, daß am Ausgang der Verstärkungseinrichtung A2 der gewünschte PeaktoPeak Spannungswert des Nutzsignals abgreifbar ist. Gegebenenfalls kann am Ausgang V die Regelspannung gemessen werden.

Die Einrichtung zur Frequenzumsetzung UDC weist ferner zwei Verbindungsknoten 6 und 7 auf, die mit den Pegeldetektoren WLD und ILD verbunden sind. Beide Pegeldetektoren besitzen einen Referenzeingang 8, dem ein Referenzpegel vorgegeben ist. Die Ausgänge 9 der Pegeldetektoren WLD und ILD sowie der Anordnung TOP, die ein aus 2 Bit bestehenden Signal aufweisen, sind mit einer Kontrollschaltung GC verbunden. Die Kontrollschaltung GC weist ferner die Eingänge CLK, S1 und S2 auf. Am Eingang CLK wird ein Taktsignal zugeführt. Die Eingänge S1 und S2 dienen zur externen Steuerung der gesamten Schaltungsanordnung. Die Kontrollschaltung enthält eine Logikanordnung, beispielsweise ein FPGA, PLD oder auch einen ASIC, der die Eingangsignale verarbeitet.

Die Kontrollschaltung GC weist ferner einen Ausgang 10 auf, der zu dem Eingang der Einstellvorrichtung CNT führt. Das Signal des Ausgangs 10 besitzt mehrere Bit Wortlänge, aus denen die Einrichtung CNT die Einstellung für die digitale Regelung ermittelt. Im vorliegenden Fall sind dies 5 Bits. 2 Bits dieses Signal werden zur Übermittlung einer Anweisung zur Erhöhung, zur Reduktion oder zur Beibehaltung der bisherigen Verstärkung verwendet. Mit den anderen Bits läßt sich die Einrichtung CNT abschalten oder in einen definierten Zustand zurücksetzen. Die Einrichtung CNK überprüft vorzugsweise bei einer steigenden oder fallenden Flanke eines am Eingang 11 angelegten Taktsignals CLK, die Bits des von der Kontrolleinrichtung kommenden Einstellsignals 10 und regelt damit das Einstellsignal für den Regeleingang 3 der Einrichtung DA.

Im dargestellten, jedoch in keinerlei Hinsicht beschränkten Ausführungsfall hat das Signal am Ausgang 12 der Einstellvorrichtung CNT eine Wortlänge von 3 Bit, was zu 8 möglichen Einstellungen am Regeleingang 3 des Regelverstärkers DA führt. Die maximale Verstärkung des Verstärkers DA beträgt +7 dB, die in 4 dB-Schritten bis auf -21 dB abnimmt. Die Einstellung ist so gewählt, daß die Bitfolge 000, also der niedrigstmögliche Zustand, der größten Verstärkungsstufe +7dB entspricht. Die höchste Bitfolge entspricht der niedrigsten Verstärkungsstufe von -21 dB. Natürlich ist es möglich diese Reihenfolge zu vertauschen, einen nicht linearen Verlauf der Verstärkungsstufen zu implementieren oder den Stufenabstand zu verändern.

Ein am Eingang 1 angelegtes Nutzsignal wird in der Einrichtung DA mit einem durch den Regeleingang 3 vorgegebenen Faktor verstärkt und gelangt an den Verbindungsknoten 6 und den Eingang des Pegeldetektors WLD. Dieser vergleicht den Signalpegel mit einem oberen und einem unteren Grenzwert, der am Eingang 8 anliegt. Der obere und untere Grenzwert ist im vorliegenden Fall durch ein digitales Signal aus 8 Bit gegeben.

Am Ausgang 9 gibt der Pegeldetektor WLD ein aus 2 Bit bestehendes Steuerungssignal aus, was je nach Ergebnis des Vergleichs eine Erhöhung der Verstärkung in der Verstärkungseinrichtung DA, eine Beibehaltung der Verstärkung oder eine Reduktion der Verstärkung signalisieren soll. Die Wortlänge des Ausgangssignals des Pegeldetektors ist dabei nicht auf 2 Bits beschränkt. Bei einer größeren Wortlänge des Ausgangs 9 des Pegeldetektors kann dazu auch gleichzeitig die Differenz zu einem Sollwert gesendet werden.

Ist das Signal beispielsweise zu niedrig, und damit das Signal/Rauschverhältnis zu gering, so wird an die Kontrollschaltung GC ein Signal zur Erhöhung der Leistung gesendet. Die Kontrolleinrichtung GC verarbeitet dieses Signal und schickt seinerseits an die Einstellvorrichtung CNT ein Signal zur Erhöhung der Verstärkung. Bei der nächsten Flanke des Taktsignals CLK erniedrigt die Einstellvorrichtung CNT die Bitsequenz um 1 Bit und erhöht dadurch die Verstärkung um 4 dB im Regelverstärker DA. Die Art des digitale Stellsignal ist vom Eingang 3 der Verstärkungseinrichtung abhängig. Es kann sich um ein paralleles Signal oder um ein serielles Stellsignal handeln.

Genauso ist es möglich, daß die Kontrolleinrichtung GC der Einstellvorrichtung CNT nicht nur ein Signal zur Änderung sendet, sondern auch einen Wert übermittelt, um wieviel Stufen geändert werden soll. Somit ist nicht nur eine sequentielle Änderung wie im dargestellten Ausführungsbeispiel möglich, sondern auch eine direkte Einstellung der Verstärkung der ersten Verstärkungseinrichtung DA.

Gleichzeitig wird das vom Ausgang 12 der Vorrichtung CNT kommende Einstellsignal von der Einrichtung DAC in ein analoges Spannungssignal umgewandelt. Durch die Erniedrigung des digitalen Signals um 1 Bit wird somit auch das Spannungssignal am Ausgang des Konverters DAC geringer. Damit sinkt die Regelspannung am Eingang 5 des analogen Verstärkers AA, wobei die Gesamtverstärkung jedoch gleich bleibt. Durch dieses gleichzeitige Nachregeln wird der Signalsprung, der durch die sprunghafte Änderung der Verstärkung in der Einrichtung DA auftritt, verringert.

Das breitbandige HF-Signal durchläuft nach dem Pegeldetektor einen Mischer M1, mit dem es auf eine erste Zwischenfrequenz umgesetzt wird. Die Mischeinrichtung M1 weist einen nicht gezeigten abstimmbaren Lokaloszillator auf, da das benutzte Frequenzband veränderbar ist und die nicht gewünschten Frequenzbänder durch ein feststehendes Filter F1 unterdrückt werden. Nach der Selektion wird das Signal mit einer Einrichtung zur Frequenzumsetzung M2 auf eine zweite Zwischenfrequenz umgesetzt, Intermodulationsprodukte durch ein Bandpassfilter F2 entfernt und erneut mit der Verstärkungseinrichtung A1 um einen festen Faktor verstärkt.

Um eine optimale Verstärkung des HF-Signals vor und nach der Frequenzumsetzung und der Filterung zu gewährleisten, ist neben dem Pegeldetektor WLD der gleich aufgebaute Pegeldetektor ILD vorgesehen, der den Pegel des frequenzumgesetzten Signals am Punkt 7 mit einem oberen und unteren Grenzwert vergleicht.

Am Ausgang des Pegeldetektor ILD lassen sich die gleichen Signale abgreifen, die auch am Ausgang des Detektors WLD anliegen. Dieses Signal dient ebenfalls über die Kontrolleinrichtung GC zur Einstellung der Einrichtung CNT. Das auf die zweite Zwischenfrequenz umgesetzte HF-Signal wird von einem Filter F3 nochmals von Nebenprodukten befreit und der analogen Verstärkungseinrichtung AA zugeführt.

Die beiden Pegeldetektoren WLD und ILD sollen einerseits die Bildung von Intermodulationsprodukten durch Übersteuerung des Eingangs der Mischern M1, M2 bzw. Filtern F1 F2 verhindern. Andererseits detektieren sie ein zu geringen Signal/RauschVerhältnis. Dazu sind sie vorteilhaft für einen kontinuierlichen Vergleich ausgebildet. Alternativ ist aber auch ein zeitdiskreter Pegelvergleich denkbar, beispielsweise mit dem Taktsignal des Signals CLK. Anstatt des beschriebenen Vergleichs der Pegeldetektoren sind jedoch auch andere Vergleichsschaltungen denkbar, beispielsweise mit nur einem Grenzwert.

Der Detektor TOP, der das Regelsignal des Steuereingangs 5 mit einem vorgegebenen Grenzwert vergleicht, dient zur Einstellung eines Grenzwertes, bis zu dem durch die Detektoren WLD und ILD geregelt werden darf.

Kerngedanke der Erfindung ist es somit, eine Verstärkungsänderung in einem digitalen Regelelement durch eine entsprechende Änderung in einer zweiten Verstärkungseinrichtung zu kompensieren, so daß der in der digitalen Verstärkungseinrichtung auftretende Signalsprung verringert wird und die Gesamtverstärkung im wesentlichen gleich bleibt. Dies ist durch die Verbindung einer Regeleinheit mit den Regeleingängen der Verstärkungseinrichtung erreichbar. Die zweite Verstärkungseinrichtung kann sowohl als analoge Verstärkungseinrichtung, wie auch als digitale Verstärkungseinrichtung ausgebildet sein. Im letzteren Fall entfällt natürlich die Notwendigkeit Mittel zur Digital-Analog-Wandlung vorzusehen. Als Signal für den analogen Stelleingang ist neben einem Spannungssignal auch ein Stromsignal denkbar.

In der vorgestellten Ausführungsform erzeugt eine Erhöhung des Stellsignal um eine Bit eine Spannungsverringerung des umgewandelten analogen Signals. Ein Invertierer kann somit entfallen. Abhängig von anderen denkbaren Ausführungsformen können daher gemäß dem Kerngedanken der Erfindung zusätzliche Schaltungselemente zur Regelung beider Verstärkungseinrichtungen benötigt werden.

Die erfindungsgemäße Schaltungsanordnung ist dabei nicht auf die Verstärkung von empfangenen Signalen beschränkt. Ebenso ist die beschriebene Kompensationsschaltung für eine Sendeanordnung oder für allgemeine Schaltungen zur Signalverstärkung mit mehreren Verstärkungseinrichtungen denkbar. Bezugszeichenliste:
- (AA, DA):: Regelverstärker
- (UDC):: Einrichtung zur Frequenzumsetzung
- (C) :: Kondensator
- (M1, M2):: Frequenzumsetzer
- (F1, F2, F3):: Filter
- (A1, A2, A3):: Verstärkungseinrichtung
- (V):: Meßpunkt
- (DAC):: Einrichtung mit Digital/Analog-Konverter
- (SC):: Summenschaltung
- (WLD, ILD, OLD):: Pegeldetektionseinrichtung
- (TOP):: Vergleichsanordnung
- (GC):: Kontrollschaltung
- (CNT):: Einstellvorrichtung
- (CLK) :: Taktsignal
- (S1,S2):: Steuersignal
- (1,4):: Verstärkereingang
- (2):: Verstärkerausgang
- (3,5):: Regeleingang
- (6,7):: Verbindungsknoten
- (8):: Referenzeingang
- (9):: Ausgang
- (10):: Signaleingang
- (11):: Takteingang
- (12):: Signalausgang

## Patentansprüche

1. Schaltungsanordnung mit zwei einstellbaren Verstärkungseinrichtungen (DA, AA),
bei der ein Signalausgang (2) einer ersten Verstärkungseinrichtung (DA) mit einem Signaleingang (4) einer zweiten Verstärkungseinrichtung (AA) gekoppelt ist,
bei der die erste Verstärkungseinrichtung (DA) als digitaler Regelverstärker mit einem digitalen Regeleingang (3) ausgebildet ist und die zweite Verstärkungseinrichtung (AA) einen Regeleingang (5) zur Regelung ihrer Verstärkung aufweist,
**dadurch gekennzeichnet, daß**
der Eingang (5) zur Verstärkungsregelung der zweiten Verstärkungseinrichtung (AA) über ein Mittel derart mit dem Eingang (3) zur Regelung der Verstärkung der ersten Verstärkungseinrichtung (DA) verbunden ist, daß eine Änderung der Verstärkung der zweiten Verstärkungseinrichtung (AA) in eine Richtung durch eine mittels der Regelung hervorgerufene Verstärkungsänderung der ersten Verstärkungseinrichtung (DA) in die entgegengesetzte Richtung erfolgt.

2. Schaltungsanordnung nach Anspruch 1,
**dadurch gekennzeichnet, daß**
der Regeleingang (5) der zweiten Verstärkungseinrichtung (AA) als analoger Eingang ausgebildet ist und das Mittel (DAC) mit zumindest einen Digital-Analog-Konverter aufweist, der ein aus n-Bit Wortlänge bestehendes digitales Signal in ein analoges Spannungssignal umwandelt.

3. Schaltungsanordnung nach Anspruch 1 oder 2,
**gekennzeichnet durch**
eine Anordnung zur Frequenzumsetzung (UDC), die zwischen der ersten (DA) und der zweiten Verstärkungseinrichtung (AA) in dem Signalpfad angeordnet ist.

4. Schaltungsanordnung nach einem der vorherigen Ansprüche,
**gekennzeichnet durch**
zumindest eine Einrichtung zur Pegeldetektion (WLD), die mit dem Signalausgang (2) der ersten Verstärkungseinrichtung (DA) verbunden ist und nach einem Pegelvergleich mit einem oberen und unteren Grenzwert ein Ausgangssignal am Ausgang (9) abgibt.

5. Schaltungsanordnung nach einem der vorherigen Ansprüche,
**gekennzeichnet durch**
eine Einstellvorrichtung (CNT) zur Regelung einer Verstärkung, die ein Regelsignal aus n-Bits zur Einstellung der Verstärkung erzeugt und mit dem Regeleingang (3) der ersten Verstärkungseinrichtung (DA) verbunden ist.

6. Schaltungsanordnung nach Anspruch 4 und 5,
**dadurch gekennzeichnet, daß**
die Einstellvorrichtung (CNT) einen Eingang (10) zur Erzeugung des Regelsignal aufweist, der direkt oder über eine Kontrollschaltung (GC) mit dem Ausgangssignal (9) der Pegeldetektionseinrichtung (WLD) verbunden ist.

7. Schaltungsanordnung nach Anspruch 3,
**gekennzeichnet durch**
zwei Einrichtungen zur Pegeldetektion (WLD, ILD), bei der die eine mit einem Verbindungsknoten (6) am Eingang und die andere mit einem Verbindungsknoten (7) am Ausgang der Einrichtung zur Frequenzumsetzung (UDC) verbunden sind und nach einem Vergleich des entsprechenden Signalpegels mit einem vorgegebenen Wert (8) ein Signal (9) abgeben.

8. Schaltungsanordnung nach einem der vorherigen Ansprüche,
**dadurch gekennzeichnet, daß**
der Regeleingang (3) der ersten Verstärkungseinrichtung (DA) für ein Stellsignal aus n-Bit Wortlänge ausgebildet ist.

9. Verfahren zur Kompensation von Signalpegelsprüngen in Verstärkungseinrichtungen,
**dadurch gekennzeichnet, daß**
- ein erstes digitales Stellsignal an einen digitalen Regeleingang einers ersten digitalen Regelverstärkers angelegt wird,
- das erste digitale Stellsignal in ein zweites analoges Stellsignal umgewandelt wird, das an einen Regeleingang einer zweiten Verstärkungseinrichtung angelegt wird,
- ein Pegel des Ausgangssignal einer jeden Verstärkungseinrichtung mit einem oberen und einem unteren Grenzwert verglichen wird und anhand des Vergleichs ein Signal zur Reduktion, zur Erhöhung oder zur Beibehaltung der Verstärkung abgegeben wird,
- bei einer Änderung des Stellsignals am Regeleingang der ersten Verstärkungseinrichtung eine Änderung in entgegengesetzter Richtung am Eingang der zweiten Verstärkungseinrichtung derart erfolgt, daß die Gesamtverstärkung der beiden Verstärkungseinrichtungen im wesentlichen gleich bleibt.

## Claims

1. Circuit arrangement having two adjustable amplification devices (DA, AA),
in which a signal output (2) of a first amplification device (DA) is coupled with a signal input (4) of a second amplification device (AA),
in which the first amplification device (DA) is formed as digital control amplifier having a digital control input (3), and the second amplification device (AA) comprises a control input (5) for controlling its amplification,
**characterized in that**
the input (5) for controlling the amplification of the second amplification device (AA) is connected by a means with the input (3) for controlling the amplification of the first amplification device (DA) such that an alteration of the amplification of the second amplification device (AA) in a direction is performed by an alteration of the amplification of the first amplification device (DA) in the opposite direction effected by the controlling.

2. Circuit arrangement according to claim 1,
**characterized in that**
the control input (5) of the second amplification device (AA) is formed as analogue input and comprises the means (DAC) having at least one digital/analogue converter, which converts a digital signal consisting of a word length of n bits into an analogue voltage signal.

3. Circuit arrangement according to one of claims 1 or 2,
**characterized by**
an arrangement for frequency conversion (UDC), which is arranged between the first (DA) and the second amplification device (AA) in the signal path.

4. Circuit arrangement according to one of the previous claims,
**characterized by**
at least one level detection device (WLD), which is connected with the signal output (2) of the first amplification device (DA) and delivers an output signal at the output (9) after a level comparison with an upper and a lower limit value.

5. Circuit arrangement according to one of the previous claims,
**characterized by**
an adjusting device (CNT) for controlling an amplification, which generates a control signal of n bits for adjusting the amplification and is connected with the control input (3) of the first amplification device (DA).

6. Circuit arrangement according to claim 4 or 5,
**characterized in that**
the adjusting device (CNT) comprises an input (10) for generating the control signal, which is connected directly or by a control circuit (GC) with the output signal (9) of the level detection device (WLD).

7. Circuit arrangement according to claim 3,
**characterized by**
two devices for level detection (WLD, ILD), wherein the one is connected with a connection node (6) at the input and the other one is connected with a connection node (7) at the output of the device for converting frequency (UDC) and deliver a signal (9) after comparison of the corresponding signal level with a predetermined value (8).

8. Circuit arrangement according to one of the previous claims,
**characterized in that**
the control input (3) of the first amplification device (DA) is formed for a control signal of a word length of n bits.

9. Method for compensating signal level jumps in amplification devices,
**characterized in that**
- a first digital control signal is applied to a digital control input of a first digital control amplifier,
- the first digital control signal is converted into a second analogue control signal, which is applied to a control input of a second amplification device,
- a level of the output signal of each amplification device is compared with an upper and a lower limit value and a signal for reducing, for increasing or for maintaining the amplification is delivered on the basis of the comparison,
- in case of an alteration of the control signal at the control input of the first amplification device an alteration is performed at the input of the second amplification device in the opposite direction such that the total amplification of the two amplification devices remains essentially constant.

## Revendications

1. Circuit ayant deux dispositifs (DA, AA) d'amplification réglables,
dans lequel une sortie (2) du signal d'un premier dispositif (DA) d'amplification est couplée à une entrée (4) du signal d'un deuxième dispositif (AA) d'amplification,
dans lequel le premier dispositif (DA) d'amplification est constitué sous la forme d'un amplificateur numérique de régulation ayant une entrée (3) numérique de régulation et le deuxième dispositif (AA) d'amplification a une entrée (5) de régulation pour la régulation de son amplification,
**caractérisé en ce que**
l'entrée (5) pour la régulation de l'amplification du deuxième dispositif (AA) d'amplification est reliée par un moyen à l'entrée (3) de régulation de l'amplification du premier dispositif (DA) d'amplification, de façon à ce qu'une modification de l'amplification du deuxième dispositif (AA) d'amplification dans un sens s'effectue par une modification de l'amplification provoquée au moyen de la régulation du premier dispositif (DA) d'amplification dans le sens contraire.

2. Circuit suivant la revendication 1,
**caractérisé en ce que**
l'entrée (5) de régulation du deuxième dispositif (AA) d'amplification est constituée sous la forme d'une entrée analogique et le moyen (DAC) a au moins un convertisseur numérique-analogique, qui transforme un signal numérique constitué d'une longueur de mot de n bits en un signal de tension analogique.

3. Circuit suivant la revendication 1 ou 2,
**caractérisé par**
un dispositif de conversion (UDC) de la fréquence, qui est monté entre le premier (DA) et le deuxième (AA) dispositifs d'amplification dans le trajet du signal.

4. Circuit suivant l'une des revendications précédentes,
**caractérisé par**
au moins un dispositif de détection (WLD) de niveau, qui est relié à la sortie (2) du signal du premier dispositif (DA) d'amplification et qui, après une comparaison de niveau avec une valeur limite supérieure et inférieure, émet un signal de sortie à la sortie (9).

5. Circuit suivant l'une des revendications précédentes,
**caractérisé par**
un dispositif (CNT) de régulation, pour réguler une amplification, qui produit un signal de régulation composé de n bits pour régler l'amplification et qui est relié à l'entrée (3) de régulation du premier dispositif (DA) d'amplification.

6. Circuit suivant les revendications 4 et 5,
**caractérisé en ce que**
le dispositif (CNT) de régulation a une entrée (10) de production du signal de régulation, qui est reliée directement ou par un circuit (GC) de contrôle au signal (9) de sortie du dispositif (WLD) de détection du niveau.

7. Circuit suivant la revendication 3,
**caractérisé par**
deux dispositifs de détection (WLD, ILD) de niveau, dans lequel l'un est relié à un noeud (6) de liaison à l'entrée et l'autre à un noeud (7) de liaison à la sortie du dispositif de conversion (UDC) de fréquence et ils émettent un signal (9) après une comparaison du niveau de signal correspondant à une valeur (8) prescrite.

8. Circuit suivant l'une des revendications précédentes,
**caractérisé en ce que**
l'entrée (3) de régulation du premier dispositif (DA) d'amplification est constituée pour un signal de régulation d'une longueur de mot de n bits.

9. Procédé de compensation de sauts de niveau du signal dans des dispositifs d'amplification,
**caractérisé en ce que**
- un premier signal numérique de réglage est appliqué à une entrée de régulation numérique d'un premier amplificateur numérique de régulation,
- le premier signal de régulation numérique est transformé en un deuxième signal de régulation analogique, qui est appliqué à une entrée de régulation d'un deuxième dispositif d'amplification,
- un niveau du signal de sortie d'un dispositif d'amplification est comparé à une valeur limite supérieure et à une valeur limite inférieure et, au moyen de la comparaison, un signal de réduction, d'augmentation ou de conservation de l'amplification est émis,
- si le signal de régulation se modifie à l'entrée de régulation du premier dispositif d'amplification, une modification dans le sens opposé à l'entrée du deuxième dispositif d'amplification a lieu, de manière à ce que l'amplification globale des deux dispositifs d'amplification reste sensiblement la même.
